# EUROPÄISCHE PATENTSCHRIFT

(11) **EP 1 911 335 B1**
(45) Veröffentlichungstag und Bekanntmachung des Hinweises auf die Patenterteilung: **11.04.2012**
(21) Anmeldenummer: 06763820.5
(22) Anmeldetag: 21.06.2006
(51) Int. Cl.: H05K 5/00, H05K 7/20, B60R 16/023

(54) **KÜHLSYSTEM FÜR ELEKTRONIKGEHÄUSE**
COOLING SYSTEM FOR ELECTRONICS HOUSINGS
SYSTEME DE REFROIDISSEMENT POUR BOITIER ELECTRONIQUE

(30) Priorität: 02.08.2005 DE 102005036299
(43) Veröffentlichungstag der Anmeldung: 16.04.2008
(73) Patentinhaber: Continental Automotive GmbH, 30165 Hannover (DE)
(72) Erfinder: KERNER, Nikolaus, 93173 Wenzenbach (DE); WEINZIERL, Christian, 94327 Bogen (DE)
(86) Internationale Anmeldenummer: PCT/EP2006/063417
(87) Internationale Veröffentlichungsnummer: WO 2007/014801

(56) Entgegenhaltungen:
- WO-A-02/35899
- WO-A-2004/085209
- DE-A1- 3 522 127
- JP-A- 3 030 399
- US-A- 5 829 516

## Beschreibung

Die Erfindung betrifft ein mit Flüssigkeit durchströmtes Kühlsystem zum Abführen von Abwärme für Elektronikgehäuse, insbesondere für den Automobilbereich.

Im Bereich der elektronischen Steuergeräte für das Motormanagement eines Automobils werden die thermischen Anforderungen an die Elektronik immer umfangreicher. Dies kann im Wesentlichen auf die Zunahme der Funktionen zurückgeführt werden, für deren Umsetzung zusätzliche Bauelemente benötigt werden. Durch diese zusätzlichen Bauelemente nimmt auch die Verlustleistung zu. Durch die Nähe zum Motorbereich werden insbesondere hohe Anforderungen an die Temperaturstabilität der elektronischen Steuergeräte gestellt. Dies führt dazu, dass die Temperaturen in den internen Verbindungen wie z.B. Lötstellen als auch in den Bauelementen zulässige Grenzen übersteigen können. Als Folge davon können Probleme hinsichtlich der Lebensdauer auftreten.

Grundsätzlich ist das Problem der Überhitzung durch aktive Kühlung mit Flüssigkeitskühlern zu lösen. Bekannte Konzepte für flüssigkeitsgekühlte elektronische Steuergeräte basieren in der Regel auf zusätzlichen Kühlern, die an oder in die E-lektronikeinheit gebaut werden. Damit ist eine gute Entwärmung der Elektronik möglich.

Die DE 198 42 615 A1 beschreibt ein elektronisches Gerät, das ein Gehäuse aufweist, in dem ein Leiterplattenmodul untergebracht ist. Eine Zwangskühlungseinrichtung mit Kühlrippen ist mit der Außenwandung des Gehäuses verbunden. Nachteilig ist bei dieser Lösung jedoch, dass die Kühlelemente nicht in unmittelbarer Nähe zu den wärmeabstrahlenden elektronischen Bauelementen angeordnet sind, sondern jeweils seitlich, was zu einem erhöhten Raumbedarf führt. Zudem eignen sich diese Kühler auch nicht dazu, eine auf mehrere Leiterplattenebenen verteilte Elektronik zu kühlen, da es sich in der Regel um ebene Konstruktionen handelt. Eine Lösung dieses Problems besteht momentan in der Verwendung mehrerer Kühler bzw. speziell geformter Kühler, die jedoch hinsichtlich ihrer Herstellung bzw. Montage wieder einen erhöhten Aufwand erfordern.

Aus der WO 2004/085209 A1 ist eine elektrische Kontrolleinheit (ECU) für Kraftfahrzeuge bekannt. Diese ECU umfasst eine Leiterplatte mit elektronischen Bauelementen und einer Kühleinheit, die in thermischer Verbindung mit der Leiterplatte steht. Diese Kühleinheit umfasst ein Rohr mit einer Kühlflüssigkeit.

Aus der DE 35 22 127 A1 ist eine kühlbare Einrichtung zur Aufnahme von elektrischen Baugruppen bekannt. Diese Einrichtung umfasst einen C-förmigen Grundkörper mit Aufnahme-, Führungs- und Klemmorganen, welche eine Baugruppe an eine Kühlplatte des Grundkörpers andrücken. Die andere Seite der Kühlplatte ist mit einem eingearbeiteten Kühlkanal ausgebildet und mit einer Abdeckplatte versehen. Zu- und Abfluss des Kühlkanals sind so angeordnet, dass auf einer Seite der Kühlplatte der Zufluss und auf der anderen Seite der Abfluss erfolgt.

Aus der WO 02/35899 A1 ist eine Kühlvorrichtung für elektronische Komponenten/Schaltungen mit einem im Wesentlichen flachen Metallgehäuse mit Flüssigkeitskühlung bekannt. Das Metallgehäuse weist mehrere Auflageflächen zur thermischen leitenden Kontaktierung von Halbleiterelementen auf. Im Gehäuse verläuft ein Kühlkanal, der mit einem Volumenstrom von Kühlflüssigkeit durchspült werden kann.

Hiervon ausgehend liegt der Erfindung die Aufgabe zugrunde, ein Kühlsystem mit einer platzsparenden, kompakten Bauweise zu schaffen, das auch über mehrere Leiterplattenebenen hinweg eine sichere Kühlung gewährleistet.

Diese Aufgabe wird durch ein Kühlsystem für Elektronikgehäuse mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.

Das erfindungsgemäße Kühlsystem zeichnet sich dadurch aus, dass es an die Geometrie des Gehäuses angepasst ist. Dadurch wird eine platzsparende, kompakte Bauweise des gesamten E-lektronikgeräts ermöglicht, da für das Kühlsystem kein zusätzlicher Bauraum benötigt wird. Zudem führt die geometrische Anpassung des Kühlsystems an das Gehäuse vorteilhaft dazu, dass direkt an den wärmeabstrahlenden elektronischen Bauelementen gekühlt wird. Das Kühlsystem ist über mehrere Leiterplattenebenen angeordnet. Dadurch ist es möglich, dass die verlustleistungsbehafteten Bauelemente besser verteilt werden und durch die direkte Kühlung am Wärmeabstrahlenden Bauelement Wärmespitzen vermieden werden. Das erfindungsgemäße Kühlsystem wird im Wesentlichen durch eine mäanderartige Kühlschlange gestellt, die aus einem Rohr durch einfaches Biegen in die gewünschte Geometrie verformt wird. Durch dieses sehr einfache Herstellungsverfahren können auch sehr anspruchsvolle Gehäusegeometrien mit einer effektiven Kühlung versehen werden. Das Kühlsystem wird außerhalb, also auf der den Leiterplatten abgewandten Seite des Gehäuses angeordnet, so dass die Kühlflüssigkeit nicht in unmittelbarem Kontakt zu den elektronischen Bauelementen steht, wenn es zu einem Defekt kommen sollte.

Bevorzugt ist es, ein einteiliges Kühlsystem zu verwenden, da auf diese Art keinerlei Dichtungsprobleme auftreten können.

Um eine effektive Kühlung zu gewährleisten, ist es zudem vorteilhaft, wenn das erfindungsgemäße Kühlsystem aus einem wärmeleitenden Material, wie z.B. Aluminium, hergestellt ist.

Zur sicheren Lagerung des erfindungsgemäßen Kühlsystems ist es darüber hinaus vorteilhaft, wenn dieses in einer Führungsnut angeordnet ist, so dass eine feste Positionierung und damit eine kontinuierliche Kühlung gewährleistet sind.

Des Weiteren ist es vorteilhaft, dass der Rohrdurchmesser des Kühlsystems variabel zwischen 4 mm bis 20 mm, insbesondere zwischen 8 bis 18 mm, ausgebildet ist, und somit je nach den gewünschten Bedingungen ausgewählt werden kann, wobei das Kühlsystem für alle möglichen, konstuktiv sinnvollen Durchmesser anwendbar ist.

Besonders bevorzugt ist es, wenn das Kühlsystem aus einem korrisionsbeständigen Material hergestellt ist, da es außerhalb des Gehäuses gelagert ist und somit mit Salzsprühnebeln, Wasser oder anderen, teils chemisch aggressiven, Substanzen wie z.B. Laugen, Säuren oder Reinigungsmitteln in Kontakt kommen kann.

Die vorliegende Erfindung schafft erstmals vorteilhaft ein effektives Kühlsystem für Elektronikgehäuse über mehrere Leiterplattenebenen hinweg mit platzsparender, kompakter Bauweise. Sie eignet sich insbesondere für Anwendungen im Automobilbereich.

Weitere Vorteile und Ausgestaltungen der Erfindung werden nachfolgend anhand eines Ausführungsbeispiels sowie anhand der Zeichnung erläutert.

Dabei zeigen schematisch:
- Fig. 1: in einer perspektivischen Darstellung ein erfindungsgemäßes Kühlsystem; und
- Fig. 2: in einer Schnittdarstellung das erfindungsgemäße Kühlsystem nach Fig. 1.

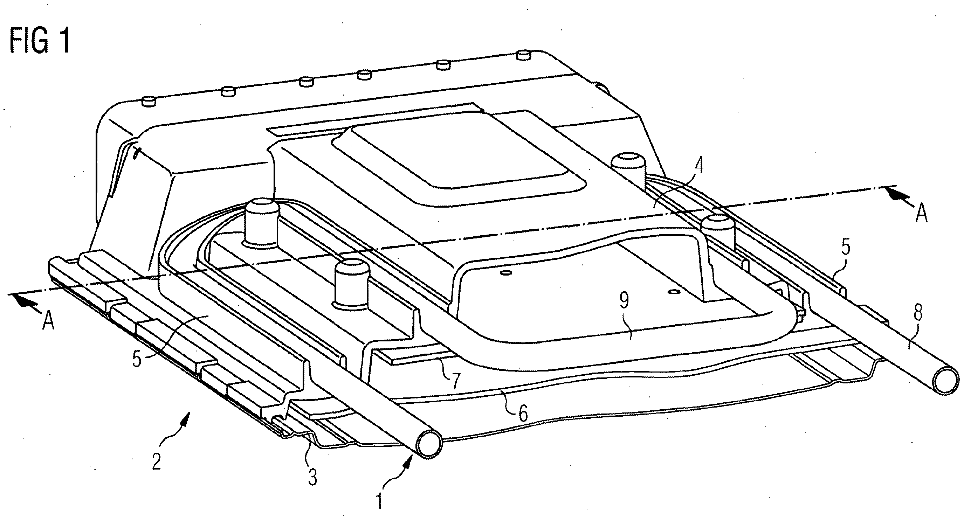

Fig. 1 zeigt in einer perspektivischen Darstellung ein erfindungsgemäßes Kühlsystem 1 für Elektronikgehäuse im montierten Zustand. Das in Fig. 1 dargestellte Elektronikgehäuse 2 umfasst ein Gehäuseunterteil 3 sowie ein Gehäuseoberteil 4, auf welchem das Kühlsystem 1 in, vorzugsweise symmetrisch angeordneten U-förmigen Führungsnuten 5 gelagert ist. Dabei sind die Schenkel der U-förmigen Führungsnut 5 nicht auf gleicher Ebene, sondern positionsgleich zu den im Inneren des Eletkronikgehäuses 2 gelagerten Leiterplattenebenen 6 und 7 angeordnet. Insgesamt ergeben sich drei Ebenen. Ebene 1 umfasst den Bauraum zwischen Gehäuseunterteil 3 sowie Leiterplattenebene 6. Ebene 2 umfasst den Bauraum zwischen den Leiterplattenebenen 6 und 7. Die dritte Ebene wird durch die Leiterplattenebene 7 und das Gehäuseoberteil 4 begrenzt. Das Kühlsystem 1, das vorzugsweise durch eine mäanderartige Kühlschlange 8 ausgebildet ist, lagert außerhalb des Gehäuses 2, also auf der den Leiterplatten (6, 7) abgewandten Seite des Gehäuses, in den symmetrisch vom Gehäusemittelpunkt angeordneten U-förmigen Führungsnuten 5 auf den Ebenen 2 und 3, die durch einen Übergangsbereich 9 auf der Ebene 3 miteinander verbunden sind. Das erfindungsgemäße Kühlsystem 1 lagert somit in unmittelbarer Nähe zu den Leiterplattenebenen 6 und 7. Die mäanderartige Kühlschlange 8 ist vorzugsweise einteilig ausgebildet und aus einem wärmeleitenden und korrosionsbeständigen Material hergestellt. Die Kühlschlange 8 weist vorzugsweise einen Durchmesser von 4 bis 20 mm, insbesondere von 8 bis 18 mm auf.

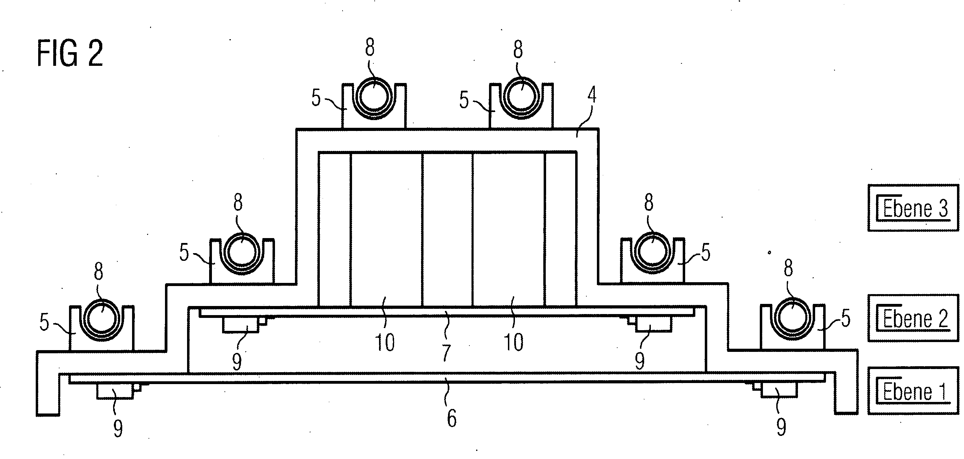

Fig. 2 zeigt in einer Schnittdarstellung das erfindungsgemäße Kühlsystem 1 auf den drei Ebenen des Elektronikgehäuses 2. Das Elektronikgehäuse ist mit Hochleistungsbauelementen wie z.B. Halbleiterelementen 9 bzw. Kondensatoren 10 bestückt. Die Halbleiterbauelemente 9 sind jeweils unterhalb der Leiterplattenebene 6 bzw. 7 und direkt unter der in der Führungsnut befindlichen Kühlschlange 8 angeordnet. Im Bereich der Halbleiterbauelemente 9 sind die Leiterplattenebenen 6 und 7 teilweise durchbrochen, um eine kontinuierliche Wärmeabfuhr der sich erwärmenden Halbleiterbauelemente zu gewährleisten. Die Kondensatoren 10 befinden sich auf der Ebene 3 und lagern auf der Leiterplattenebene 7. Die Kühlung dieser Bauelemente erfolgt durch die flüssigkeitsdurchströmte Kühlschlage 8, die sowohl oberhalb des Gehäuseoberteils 4 als auch seitlich auf Ebene 2 gelagert ist, wobei als Kühlflüssigkeit vorzugsweise Kühlwasser des Motorkühlkreislaufs verwendet wird. Es kann aber auch jedes andere Medium verwendet werden, sofern ein entsprechender Kühlkreislauf aufgebaut wird, oder das erfindungsgemäße Kühlsystem in einer anderen Umgebung, also nicht im Fahrzeug, eingesetzt wird.

Die vorliegende Erfindung schafft erstmals vorteilhaft ein effektives Kühlsystem für Elektronikgehäuse über mehrere Leiterplattenebenen hinweg mit platzsparender, kompakter Bauweise. Sie eignet sich insbesondere für Anwendungen im Automobilbereich.

## Patentansprüche

1. Elektronikgehäuse (2) für den Automobilbereich mit einem flüssigkeitsdurchströmten Kühlsystem (1) zum Abführen von Abwärme, umfassend wenigstens zwei auf verschiedenen Ebenen angeordnete Leiterplatten (6, 7), wobei das flüssigkeitsdurchströmte Kühlsystem (1) eine einteilige mäanderartige Kühlschlange (8) aufweist, welche auf der den Leiterplatten (6,7) abgewandten Seite des Elektronikgehäuses (2) und über mehrere Leiterplattenebenen (6,7) angeordnet ist, wobei das Kühlsystem (1), das in einer Führungsnut gelagert ist, an die Geometrie des Gehäuses (2) angepasst ist.

2. Elektronikgehäuse (2) nach Anspruch 1, **dadurch gekennzeichnet, dass** das Kühlsystem (1) einteilig ausgebildet ist.

3. Elektronikgehäuse (2) nach Anspruch 1 oder 2, **dadurch gekennzeichnet, dass** das Kühlsystem (1) aus einem wärmeleitenden Material, insbesondere aus Aluminium, hergestellt ist.

4. Elektronikgehäuse (2) nach einem der Ansprüche 1 bis 3,
**dadurch gekennzeichnet, dass** das Kühlsystem (1) ein Rohrdurchmesser von 4 bis 20 mm, vorzugsweise von 8 bis 18 mm, aufweist.

5. Elektronikgehäuse (2) nach einem der Ansprüche 1 bis 4,
**dadurch gekennzeichnet, dass** das Kühlsystem (1) aus einem korrosionsbeständigen Material hergestellt ist.

## Claims

1. Electronics housing (2) for the automobile sector with a cooling system (1) having liquid flowing through it for removal of waste heat, comprising at least two printed circuit boards (6, 7) arranged on different levels, therein the cooling system (1) having liquid flowing through it has a one-piece serpentine cooling tube (8) which is arranged on the side facing away from the electronic housing (2) and over a number of circuit board levels (6, 7), wherein the cooling system (1) is supported in a guidance slot, adapted to the geometry of the housing (2) .

2. Electronics housing (2) according to claim 1,
**characterised in that** the cooling system (1) is embodied in one piece.

3. Electronics housing (2) according to claim 1 or 2,
**characterised in that** the cooling system (1) is manufactured from a heat-conducting material, especially from aluminium.

4. Electronics housing (2) according to one of claims 1 to 3, **characterised in that** the cooling system (1) has a tube diameter of 4 to 20 mm, preferably of 8 to 18 mm.

5. Electronics housing (2) according to one of claims 1 to 4, **characterised in that** the cooling system (1) is manufactured from a corrosion-resistant material.

## Revendications

1. Boîtier électronique (2) destiné au domaine automobile, comprenant un système de refroidissement (1) traversé par un liquide pour l'évacuation de chaleur perdue, comprenant au moins deux cartes de circuits imprimés (6, 7) agencées dans des plans différents, dans lequel le système de refroidissement (1) traversé par un liquide présente un serpentin de refroidissement (8) d'un seul tenant, formant des méandres, lequel est agencé sur le côté du boîtier électronique (2) opposé aux cartes de circuits imprimés (6, 7) et sur plusieurs plans de cartes de circuits imprimés (6,7), dans lequel le système de refroidissement (1), qui est installé dans une rainure de guidage, est ajusté à la géométrie du boîtier (2).

2. Boîtier électronique (2) selon la revendication 1, **caractérisé en ce que** le système de refroidissement (1) est formé d'un seul tenant.

3. Boîtier électronique (2) selon la revendication 1 ou 2, **caractérisé en ce que** le système de refroidissement (1) est fabriqué à partir d'un matériau thermoconducteur, en particulier à partir d'aluminium.

4. Boîtier électronique (2) selon l'une quelconque des revendications 1 à 3, **caractérisé en ce que** le système de refroidissement (1) présente un diamètre de tube de 4 à 2 0 mm, de préférence de 8 à 1 8 mm .

5. Boîtier électronique (2) selon l'une quelconque des revendications 1 à 4, **caractérisé en ce que** le système de refroidissement (1) est fabriqué à partir d'un matériau résistant à la corrosion.
